# EUROPEAN PATENT SPECIFICATION

(11) **EP 0 578 737 B1**
(45) Date of publication and mention of the grant of the patent: **20.12.1995**
(21) Application number: 92909587.5
(22) Date of filing: 03.04.1992
(51) Int. Cl.: H01R 23/70, H01R 9/07, H05K 7/10

(54) **CONTACT DEVICE FOR AN ELECTRICAL OR ELECTRONIC COMPONENT**
KONTAKTVORRICHTUNG FÜR EIN ELEKTRISCHES ODER ELEKTRONISCHES BAUTEIL
DISPOSITIF DE CONTACT POUR COMPOSANT ELECTRIQUE OU ELECTRONIQUE

(30) Priority: 03.04.1991 DE 4110686
(43) Date of publication of application: 19.01.1994
(73) Proprietor: MINNESOTA MINING AND MANUFACTURING COMPANY, St. Paul, Minnesota 55133-3427 (US)
(72) Inventor: PLÖHN, Günter, D-2407 Bad Schwartau (DE); TRAPP, Burkhard, D-2000 Hamburg 60 (DE)
(74) Representative: Graalfs, Edo, Dipl.-Ing. Patentanwälte Hauck, Graalfs, Wehnert, Döring, Siemons
(86) International application number: EP9200757
(87) International publication number: WO9217921

(56) References cited:
- EP-A- 0 195 871
- EP-A- 0 214 719
- EP-A- 0 358 404
- DE-A- 3 026 341
- US-A- 4 894 015

## Description

### BACKGROUND OF THE INVENTION

The invention refers to contact device for an electrical or electronic component, in particular for connectors.

In the design of electrical or electronic circuit there is a considerable saving of space by placing the electrical or electronic components directly on the printed circuit board. Further space is saved by connecting the contacts of the components to the conductors on the surface of the printed circuit boards on which the conductors are printed. In this case it is not necessary to project through apertures in the printed circuit boards.

Prior art contacts suffer from mechanical stresses at the soldering joints caused by the galvanic connection of the contacts to the printed circuit boards. For connectors with pins and sockets it is required that the contacts have sufficient resiliency to allow good electrical connection. The external contact portion projecting over the housing of the connector has of course the same material properties as the remaining portion of the contact. The connection to the printed circuit board, thus, causes various problems.

During the soldering process the heat applied may result in a bending of the printed circuit board. This may cause mechanical stress at the soldering joints after cooling.

Due to irregularities of the printed circuit boards such as roughness, the components to be soldered must be pressed against the printed circuit board to assure that all contact portions safely engage the conductors of the printed circuit board. After soldering, more or less stresses are left in the external contact portions acting on the soldering joints.

The soldering is usually carried out at temperatures up to 250°C. Due to different temperature expansion factors the parts shrink differently which also results in stresses on the soldering joints after cooling.

During operation variations in temperature built up stresses on the soldering joints.

Furthermore, handling the connector exerts mechanical stresses on the soldering joints, in particular when the contacts are floatingly supported in the connector housing. A floating support may contribute to reducing the above mentioned stresses to the soldering joints. However, this advantage is accompanied by larger stresses in the connecting and disconnecting operation of the connector parts.

British patent application GB 2 173 652 and the European patent application EP 0 200 449 teach to let the outer contact portions extend over the margins of the housing of the electrical or electronic components and to make them flexible in a specific manner. This reduces the mechanical stresses at the soldering joints to some extent, however, the main problem mentioned above is not solved.

The US-A-4 894 015 describes an interconnect assembly for electrically connecting a connector housing having pin connectors with tail ends outside of the connector and downwardly extending and a circuit board having a printed conductor pattern thereon. A thin flexible sheet of dielectric polymeric material has holes through which the tail ends extend. A further flexible sheet is placed on the printed circuit board. A plurality of electrically conductive runners interconnects the sheet portions and establishes an electrical connection with the conductors of the printed circuit board.

### SUMMARY OF THE INVENTION

The present invention provides a contact means for an electrical or electronic component, particularly a connec tor, wherein the mechanical forces acting on the soldering joints of printed circuit boards are considerably reduced.

According to the invention the outer contact portion includes an individual flexible sheet portion provided with at least a conductor. The internal or component contact portion is spaced from the printed circuit board.

Prior art contact devices are often made integrally and extend beyond the housing of the component with its outer contact portion to be connected to a conductor of a printed circuit board by soldering. According to the invention, however, the outer contact portion is a separate part formed by flexible sheet portions provided with at least a conductor. Providing a conductor to a flexible sheet meets no problems. Preferably, the conductor is printed on the sheet portion. The sheet portion is preferably made of plastic material and is sufficiently flexible, such that displacements of the inner conductive portion, thermal expansions and irregularities of the printed circuit boards do not result in substantial stresses to be exerted to the soldering points.

The connection of the inner contact portions with the sheet portion can be carried out very simply. Preferably, the inner contact portion projects a certain length over the housing of the component. The free end of the inner contact portion, thus, can be directly connected to the associated conductive parts of the sheet portion. Alternatively, the outer end of the internal contact portion can extend through an opening in the sheet portion. For this, an opening can be preformed in the sheet portion. Alternatively, the free end of the internal contact portion can be formed as a cutting or punching tool which automatically pierces through the sheet portion when the component is brought into engagement with the sheet portion. The sheet portion can be attached to the outer end of the internal contact portion in different ways, e.g. by soldering, welding, glueing, crimping, etc.

When a plurality of contacts of the component is to be connected to the printed circuit board, according to an embodiment of the invention, the sheet portion can be provided with a plurality of conductors to be connected to a group of internal contact portions. For even larger numbers of contacts it is recommended to provide a plurality of sheet portions each having a plurality of conductors to prevent stresses on the sheet portion due to deformations. When the sheet portion has a plurality of conductors, according to a still further embodiment of the invention, cut-out portions can be provided between adjacent conductors extending from the outer edges of the sheet portion towards the component.

Instead of a larger continuous sheet portion, alternatively, a plurality of strip-shaped sheet portions can be provided each having one or more conductors applied. The strip-shaped sheet portions can be attached to each other by at least a transversely extending tape which may be attached for example to the lower surface of the strip-shaped sheet portions, e.g. using an adhesive.

In automatically operated soldering processes it is known to utilize a liquid to clean the soldering joints after soldering. According to a further embodiment of the invention, the sheet portion may be attached to the inner contact portions such that a space is left between the inner contact portions and a printed circuit board. This allows a cleaning liquid to reach the soldering joints between the internal contact portions and the conductors of the sheet portion.

According to the invention, the internal contact portions may project downwardly beyond the component ending in a distance from the printed circuit board. In connecting the internal contact portions the sheet portion is pressed from below towards the component. In order to provide the free space referred to the housing of the component has preferably a depression at the lower surface in the region of the internal contact portion. When the sheet portion is brought into engagement with the lower side of the component the sheet portion is displaced into the depression and, thus yields the space with respect to the printed circuit board.

### BRIEF DESCRIPTION OF THE DRAWINGS

A number of preferred embodiments of the invention will be subsequently described with reference to the drawings which show
- Fig. 1,: a perspective view of a first embodiment of a contact device according to the invention
- Fig. 2,: a perspective view of a second embodiment of contact devices according to the invention
- Fig. 3,: a perspective view of a third embodiment of a contact device according to the invention and
- Fig. 4,: a perspective view of a fourth embodiment of a contact device according to the invention for a different connector
- Fig. 5: a perspective view of a portion of Fig. 4 in enlarged scale indicated by a circle.

### DETAILED DESCRIPTION OF THE DRAWINGS

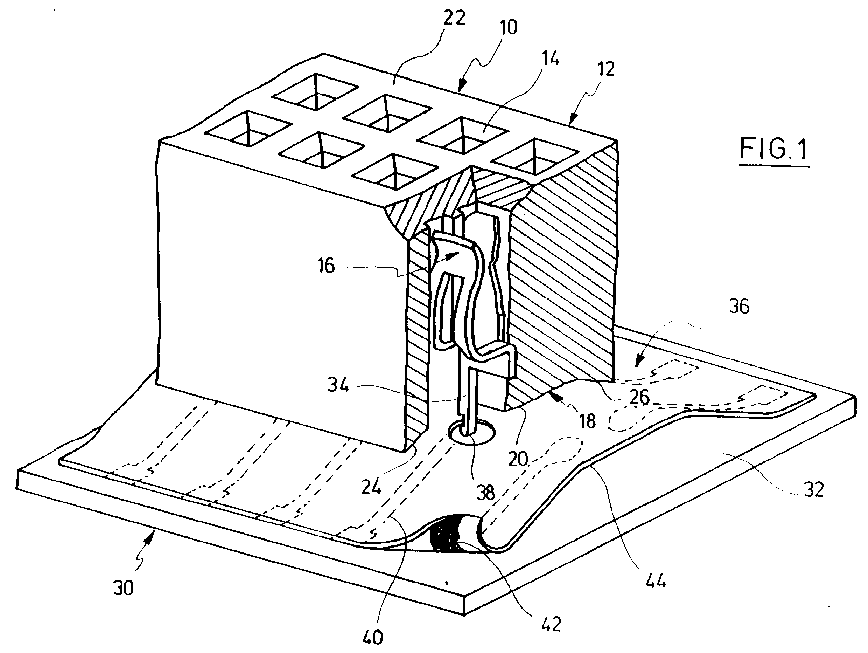

Fig. 1 shows a portion of a connector 10 having a rectangular elongate housing 12. Two rows of square openings 14 are formed in the upper side of housing 12. Each opening 17 is associated with a socket contact 16 defining an internal contact portion which is fixedly attached in housing 12. The socket contact consists of a suitable metallic spring material, e.g. beryllium copper, phosphorous bronze or the like. The shape of the contact 16 is conventional. It is utilized to receive a contact pin (not shown) to make an electrical connection.

The lower side of the housing 12 has an elongate recess 18 defined by a first surface 20 spaced from and parallel to the upper side 22 of the housing 12 and two lateral inclined surfaces 24, 26. The connector 10 is placed on the printed circuit board 30, with the printed circuit not shown in detail. The inclined surfaces 24, 26 space the surface 20 from the upper surface 32 of the printed circuit board.

The socket contact 16 includes downwardly extending pin 34 which slightly projects beyond the lower surface 20, and terminates at a distance from the upper surface 32 of the printed circuit board 30. The connector interface of the present invention further includes flexible sheet 36, preferrably made of plastic material, e.g. of polyimide, is placed between the lower side of the housing 12 and the upper surface 32 of the printed circuit board 30. The pin 34 of the contact extends through a preformed aperture 38 in the sheet 36. Alternatively, the pin 38 can be formed as a punching or cutting tool which automatically cuts a hole in the sheet 36 when the sheet 36 is placed on the lower side of the housing 12.

A number of conductive paths 40 shown in dotted lines are printed on the lower surface of the sheet 36. As shown a pad 42 and a conductor 40, printed on the lower side, is illustrated by bending the sheet 36 over. As can be seen, each contact 16 of the connector 10 is provided to cooperate with a conductor 40, which extends from either side of the pin 34 beyond the lateral ends of the housing 12. As can be seen further, the sheet 36 is significantly broader in dimension than the housing 12. The electrical connection between the pin 34 and the conductor 40 can be, for example, made by soldering. However, the connection can be made by welding, glueing or crimping as well. For this manufacturing step the sheet 36 is pressed against the lower side of the housing 12 into the recess 18 so that the sheet correspondingly forms an intermediate space 44 with respect to the upper surface 32 of the printed circuit board 30. The conductors 40 of the sheet 36 are connected to conductors not shown on the circuit board 30, in particular by soldering. After soldering the pins 34 to the conductors 40 the space 44 allows a cleaning step using a suitable liquid. Soldering the conductors on the flexible sheet to the printed circuit board 30 can be made in a conventional manner, e.g. by means of thermopins, thermo-tongs, by using hot gas or the like.

Owing to the large flexibility of the sheet 36, mechanical forces caused by thermal expansion, motions of the contacts 16, irregularities of the printed circuit board 30 or housing 12 are prevented from being applied to the soldering joints between the conductors 40 and conductors of the printed circuit board 30.

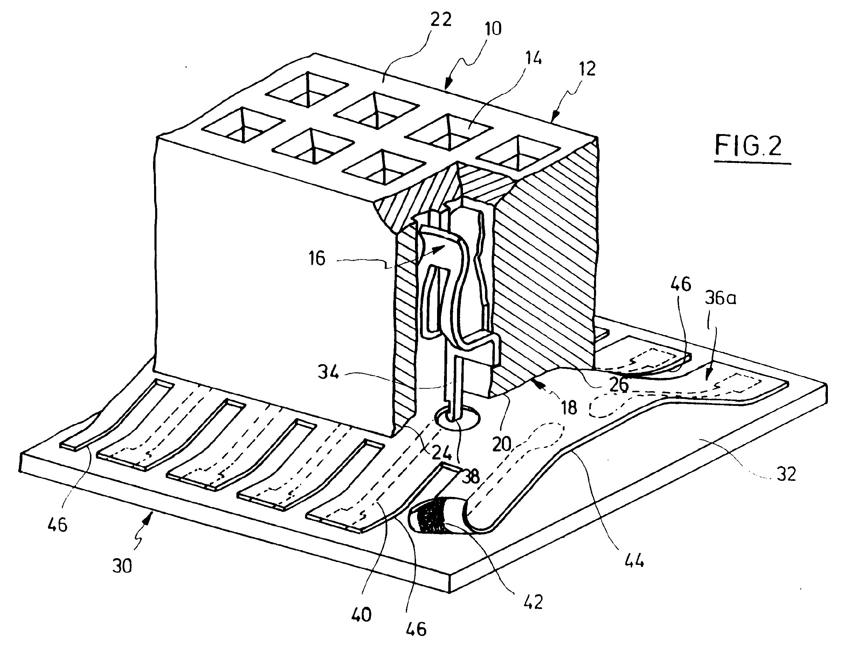

The embodiment of Fig. 2 is substantially similar to that of Fig. 1 so that identical parts carry the same reference numbers. In Fig. 2, a sheet 36a is shown which has elongated rectangular cuts 46 between adjacent conductors 40 which cuts extend from the edges of the sheet towards the connector 10. Thus the sheet 36a is comb-shaped, increasing its flexibility over that of sheet 36 in the embodiment of Fig. 1. Therefore, it can even more easily compensate for deformations of the housing 12 or of the printed circuit board 30.

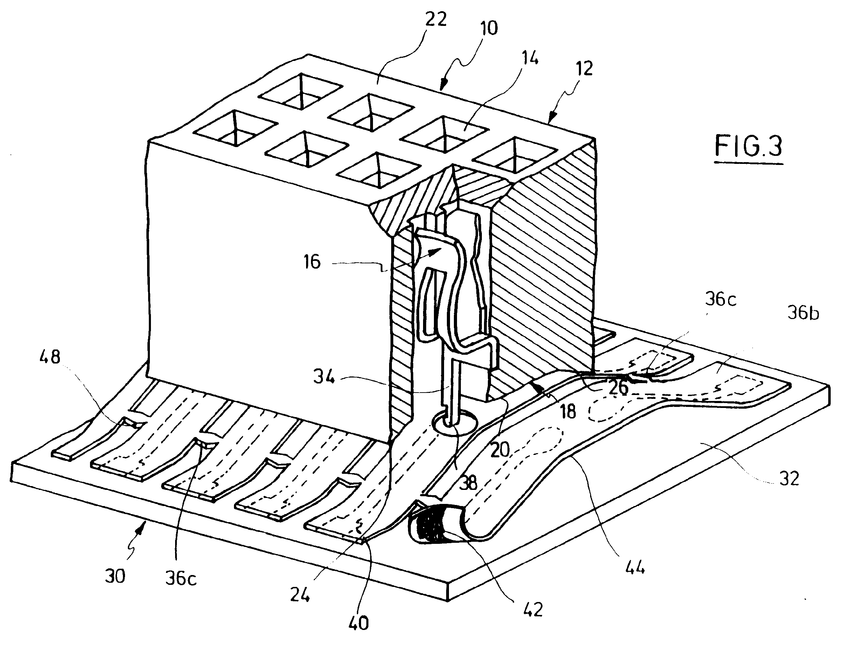

As far as parts of the embodiment of Fig. 3 are identical to those of the embodiment of Figs. 1 and 2, they carry the same reference numerals. In Fig. 3, the sheet 36b is cut to form a number of strips of sheet material arranged in a spaced relationship parallel to each other. Each strip is provided with two conductors 40 at the lower side thereof. Thus, each strip of the sheet 36b is provided with a pair of contact pieces of the connector 10, with the conductors 40 soldered to the printed circuit board 30 in the manner described above. The sheet 36b can be made of the same material as the sheets 36 and 36a, and the strips are held together with bridging web portions 48. The sheet is displaced towards the lower side of housing 12 such that an intermediate space 44 results similar to the embodiments of Figs.1 and 2.

The bridging webs 48 could be defined by portions of an adhesive tape which interconnects the lower sides of the strips of sheet 36b on either side of the housing 12.

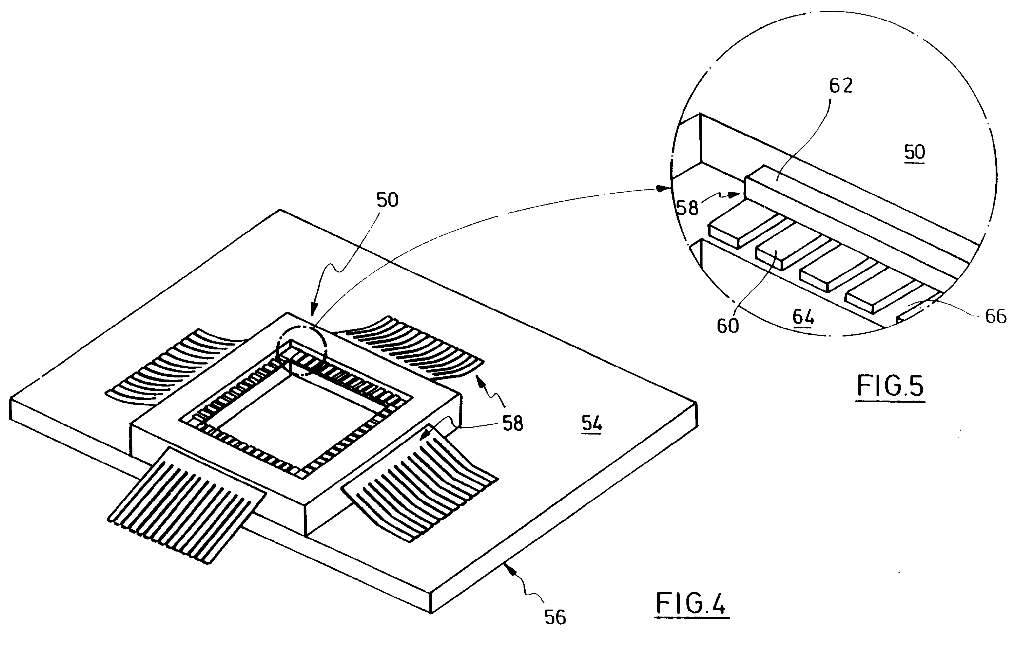

Fig. 4 shows a square frame-shaped housing 50 for the receipt of an IC, e.g. silicon chip (not shown) in the interior thereof. The housing 50 is placed on the upper surface of a printed circuit board 56. Flexible sheets 58 including conditions on the lower side thereof (not shown) are located on each side of the housing 52. As can be seen, the outer portions of sheets 58 are comb-shaped as illustrated in Fig. 2. The conductors thereof are soldered to the conductors (not shown) of the printed circuit board 56.

The sheets 58 are inserted into the housing and retained therein, e.g. by clamping means (not shown). The inner ends of the sheets 58 project into the interior of the housing. As can be seen in Fig. 5, conductors 60 of the sheets 58 are freed from the sheet material 62, e.g. by cutting or etching process. This serves for the connection with the terminals of the IC (indicated at 64) which is placed into the housing 50. The exposure of the conductors 60 allows the use of conventional techniques, e.g. wire-bonding.

As can be seen, the inner end of the sheet portions and the conductors 60 ly on a shoulder 66 formed at the housing 50 adjacent the free inner space thereof.

## Claims

1. An arrangement of an electrical connector, a flexible sheet portion and a printed circuit board (PCB), the connector comprising a housing (12) and at least one internal contact (16) within the housing (12), the contact having an internal contact portion (34) projecting beyond the housing (12) with a space left between the printed circuit board (30) and the internal contact portion (16) and the flexible sheet portion (36, 36a, 36b) supporting at least one conductor (40) and being located between the housing (12) and the PCB (30), with the conductor (40) of the sheet portion (36, 36a, 36b) connected to the internal contact portion (16) and to the conductor (40) on the PCB (30), characterized in that the connector housing (12) is mounted on the PCB (30) and only a continuous integral polymeric sheet portion (36, 36a, 36b) is provided with said conductors (40) printed thereon, the conductors (40) being electrically connected to the internal contact portion (16) and the conductor (40) of the PCB.

2. The contact device of claim 1, wherein the outer end of the internal contact portion (16) extends through an aperture (38) in the sheet portion (36, 36a, 36b).

3. The contact device of claim 2, wherein the aperture (38) in the sheet portion is fabricated.

4. The contact device of claim 2, wherein the outer end (34) of the internal contact portion (16) is formed as a cutting or punching tool.

5. The contact device of claim 1, wherein the sheet portions (36, 36a, 36b) has a plurality of conductors which are connected to a group of the internal contact portions (16).

6. The contact device of claim 5, wherein a plurality of cuts (46) is formed adjacent to the conductor (40) which cuts (46) extend from the outer edges of the sheet portion (36a) towards the housing (16).

7. The contact device of claim 1, wherein a plurality of strip-shaped sheet portions (36b) is provided, each having one or two conductors (40) to be connected to associated internal contact portions (16), and wherein the strip-shaped sheet portions (36b) are interconnected by at least a transversally extending fixing tape (48).

8. The contact device of claim 1, wherein the internal contact portion (16) projects downwardly beyond the housing (12) towards the printed circuit board (30), and wherein the sheet portion (36, 36a, 36b) is connected to the internal contact portion (16) such that there is a space (44) between the printed circuit board (30) and the sheet portion (30, 30a, 30b) adjacent to the internal contact portion (16).

9. The contact device of claim 8, wherein the lower side of the housing (12) has a recess (18) adjacent to the internal contact portion (16).

## Patentansprüche

1. Kontaktvorrichtung für ein elektrisches oder elektronisches Bauteil, das einen Verbinder, eine flexible Folie und eine Leiterplatte (PCB) aufweist, wobei der Verbinder ein Gehäuse (12) und mindestens einen internen Kontakt (16) im Gehäuse (12) aufweist, wobei der Kontakt einen inneren Kontaktabschnitt (34) aufweist, der aus dem Gehäuse (12) heraussteht, wobei ein Abstand gelassen ist zwischen der Leiterplatte (30) und dem inneren Kontaktabschnitt (16), wobei ferner der flexible Folienabschnitt (36, 36a, 36b) mindestens einen Leiter (40) aufweist und zwischen dem Gehäuse (12) und dem PCB (30) angeordnet ist, wobei der Leiter (40) des Folienabschnitts (36, 36a, 36b) mit dem internen Kontaktabschnitt (16) und mit dem Leiter (40) des PCB (30) verbunden ist, dadurch gekennzeichnet, daß das Verbindergehäuse (12) auf dem PCB (30) angebracht ist und nur ein kontinuierlicher einteiliger polymerer Folienabschnitt (36, 36a, 36b) mit den aufgedruckten Leitern (40) vorgesehen ist, wobei die Leiter (40) elektrisch mit dem inneren Kontaktabschnitt (16) und dem Leiter (40) des PCB verbunden sind.

2. Kontaktvorrichtung nach Anspruch 1, dadurch gekennzeichnet, daß das äußere Ende des inneren Kontaktabschnitts (16) durch eine Öffnung (38) im Folienabschnitt (36, 36a, 36b) hindurchgesteckt ist.

3. Kontaktvorrichtung nach Anspruch 2, dadurch gekennzeichnet, daß die Öffnung (38) im Folienabschnitt vorgeformt ist.

4. Kontaktvorrichtung nach Anspruch 2, dadurch gekennzeichnet, daß das äußere Ende des inneren Kontaktabschnitts (16) als Schneid- oder Stanzwerkzeug ausgebildet ist.

5. Kontaktvorrichtung nach einem der Ansprüche 1 bis 4, dadurch gekennzeichnet, daß die Folienabschnitte (36, 36a, 36b) mehrere Leiterbahnen aufweisen, die mit einer Gruppe von inneren Kontaktabschnitten (16) verbindbar sind.

6. Kontaktvorrichtung nach Anspruch 5, dadurch gekennzeichnet, daß zwischen den Leiterbahnen (40) Einschnitte (46) geformt sind, die sich, vom äußeren Rand des Folienabschnitts (36a) ausgehend, in Richtung des Bauteils (10) erstrecken.

7. Kontaktvorrichtung nach Anspruch 1, dadurch gekennzeichnet, daß mehrere streifenförmige, jeweils ein oder zwei Leiterbahnen aufweisende Folienabschnitte (36b) vorgesehen sind, deren Leiterbahnen mit zugeordneten inneren Kontaktabschnitten (34) verbindbar sind und die streifenförmigen Folienabschnitte (36b) durch mindestens ein querverlaufendes Halteband (48) miteinander verbunden sind.

8. Kontaktvorrichtung nach Anspruch 1, bei der der innere Kontaktabschnitt (16) nach unten in Richtung der gedruckten Schaltung (30) aus dem Bauteil (12) herausragt und bei der der Folienabschnitt (36, 36a, 36b) so mit dem inneren Kontaktabschnitt (16) verbunden ist, daß er im Bereich des inneren Kontaktabschnitts (16) einen Abstand zur gedruckten Schaltung (30) freiläßt.

9. Kontaktvorrichtung nach Anspruch 8, dadurch gekennzeichnet, daß das Gehäuse (12) des Bauteils (10) an der Unterseite im Bereich des inneren Kontaktabschnitts (34) eine Einsenkung (18) aufweist.

## Revendications

1. Disposition d'un connecteur électrique, d'une portion de feuille flexible et d'une carte de circuit imprimé (PCB), le connecteur comprenant un logement (12) et au moins un contact interne (16) à l'intérieur du logement (12), le contact ayant une portion de contact interne (34) se projetant au-delà du logement (12) avec un espace laissé entre la carte de circuit imprimé (30) et la portion de contact interne (16) et la portion de feuille flexible (36, 36a, 36b) portant au moins un conducteur (40) et étant situé entre le logement (12) et la PCB (30), avec le conducteur (40) de la portion de feuille (36, 36a, 36b) étant relié à la portion de contact interne (16) et au conducteur (40) sur la PCB (30), caractérisé en ce que le logement de connecteur (12) est monté sur la PCB (30) et qu'il n'est fourni qu'une portion de feuille polymère continue unitaire (36, 36a, 36b) avec lesdits conducteurs (40) imprimés sur celle-ci, les conducteurs (40) étant reliés électriquement à la portion de contact interne (16) et au conducteur (40) de la PCB.

2. Dispositif de contact selon la revendication 1, dans lequel l'extrémité externe de la portion de contact interne (16) se prolonge au travers d'une ouverture (38) dans la portion de feuille (36, 36a, 36b).

3. Dispositif de contact selon la revendication 2, dans lequel l'ouverture (38) dans la portion de feuille est fabriquée.

4. Dispositif de contact selon la revendication 2, dans lequel l'extrémité externe (34) de la portion de contact interne (16) est formée en tant qu'outil de découpage ou de perforation.

5. Dispositif de contact selon la revendication 1, dans lequel les portions de feuille (36, 36a, 36b) possèdent un ensemble de conducteurs qui sont reliés à un groupe des portions de contact interne (16).

6. Dispositif de contact selon la revendication 5, dans lequel un ensemble de découpes (46) sont formées adjacentes au conducteur (40), lesquelles découpes (46) s'étendent à partir des bords externes de la portion de feuille (36a) vers le logement (12).

7. Dispositif de contact selon la revendication 1, dans lequel on fournit un ensemble de portions de feuille en forme de bandes (36b), chacune ayant un ou deux conducteurs (40) à connecter aux portions de contact internes associées (16), et dans lequel les portions de feuille en forme de bande (36b) sont reliées entre elles au moyen d'au moins une bande de fixation s'étendant transversalement (48).

8. Dispositif de contact selon la revendication 1, dans lequel la portion de contact interne se projette vers le bas au-delà du logement (12) vers la carte de circuit imprimé (30), et dans lequel la portion de feuille (36, 36a, 36b) est reliée à la portion de contact interne (16) tel qu'il existe un espace (44) entre la carte de circuit imprimé (30) et la portion de feuille (30, 30a, 30b) adjacente à la portion de contact interne (16).

9. Dispositif de contact selon la revendication 8, dans lequel le côté inférieur du logement (12) possède un évidement (18) adjacent à la portion de contact interne (16).
